# EUROPEAN PATENT APPLICATION

(11) **EP 2 858 122 A1**
(43) Date of publication of application: **08.04.2015**
(21) Application number: 13799775.5
(22) Date of filing: 29.05.2013
(51) Int. Cl.: H01L 31/042, F24J 2/12, F24J 2/24

(54) **MODULAR SYSTEM FOR CAPTURING PHOTOVOLTAIC SOLAR ENERGY**

(30) Priority: 04.06.2012 ES 201200596
(71) Applicant: Investigaciones, Desarrollos e Innovaciones Tat Iberica, S.L., 28794 Guadalix de la Sierra (Madrid) (ES)
(72) Inventor: TORRES JUNCO, Vicente, 28794 Guadalix de la Sierra (Madrid) (ES)
(74) Representative: Garcia-Cabrerizo y del Santo, Pedro Maria
(86) International application number: PCT/ES2013/000131
(87) International publication number: WO 2013/182716

(57) **Abstract**

Modular system for capturing photovoltaic solar energy, comprising:
- A plurality of assemblable tubular elements (containers) (1),
- Reflective surface (12) for said containers,
- At least one tube (13) for circulation of the cooling fluid (11),
- Photovoltaic cells (14) attached to the cooling tube,
- Electric conductors to channel the energy produced,
- At least one cooling water collector (16),
wherein the containers may be containers of liquids, such as soft drink bottles manufactured for this purpose of reuse, so that once their liquid container function has been accomplished, they are reused with this application. Thus, containers that would normally be disposed of are reused for the construction of a system to capture solar energy and just purchasing the kit with the additional elements would be sufficient to assemble a system of this type at home, being substantially cheaper.

## Description

### Technical field of the invention

The present invention falls within the field of photovoltaics for domestic use, more specifically, it relates to an economical photovoltaic modular system that can be built by the users themselves.

### BACKGROUND OF THE INVENTION

The need of electricity in underdeveloped areas is a known factor. Furthermore, in such areas resources are very limited.

That is why various systems that use natural energy at the lowest price for users are being devised.

The aim of the invention is to use solar energy captured with photocells and use it for self-consumption.

To make the system profitable for the user, solar energy containers will be reused.

Patents ES2012870, ES1012204U, ES1012207U and ES1012208U disclose reusable containers consisting of a three-dimensional body wherein there is at least one coupling point in line with the container inlet and an assembly point in line with its base. These coupling and assembly areas are complementary enabling the internal communication between their volumes, allowing the tongue and groove joint between containers.

Patent DE3910540 describes a solar collector formed from a plurality of containers comprising a reflector sheet extending longitudinally and a set of V-section conduits. However, these solar collectors have a low performance and are therefore not suitable, for example, for generating electricity.

Accordingly, the invention proposes to overcome the deficiencies in the prior art with a photovoltaic solar energy capture system based on reusable containers and other components provided as a kit to users so that, with hardly no investment and without needing specialized technicians, users can assemble a system that allow them to use solar energy for their own consumption.

### Description of the invention

The invention describes a system for capturing photovoltaic solar energy for domestic use.

The system comprises the following elements:
- A plurality of assemblable tubular elements (which may be reusable containers) which may have a reflective inner surface;
- Electric conductors to channel the energy produced;
- Tubes for the circulation of the cooling water with the photovoltaic cells adhered to the tube;
- At least one collector for the cooling water, either modular or otherwise;
- Reflectors in the form of sheets to be attached on the outside of the containers in the event that these do not already have a reflective inner surface.

The system as a whole consists of a series of assemblable tubular elements (hereafter referred to as containers) which are connected to one another forming long and hollow conduits through which at least one tube for circulating cooling water runs, having the same length as the conduit created by the containers. The tube carrying the cooling water has attached, along its length, photovoltaic cells. These photovoltaic cells are connected at their ends with electrical conductors which transmit the energy produced. The cooling water, when heated, is also collected for consumption.

The system is assembled as follows:
1. Rows of containers are connected in series (a single row is possible, but most commonly there are several parallel rows) to the desired length,
2. If the containers do not have an inner reflective coating, a reflective sheet is attached to the outside,
3. The tube with the photovoltaic cells attached is inserted inside each row of containers,
4. The tubes that carry the cooling water are connected:
   - If the system configuration is in series, i.e. the same cooling water running through all the rows, the top end of the tube in the first row is connected to the water inlet and the bottom end of the tube of the first row is connected to the top end of the tube of the second row, such that the cooling water passes from one row to another until reaching the bottom end of the tube of the last row of containers, for its use,
   - If the system configuration is in parallel, i.e. the cooling water that runs through each row is independent, the top ends of each tube are connected to the water inlet and the bottom ends to a water collector,
5. Lastly, the ends of the photovoltaic cells are connected to the electrical conductors.
   The system so assembled is situated in a place with a high exposure to sunlight so that the sun shines on the photovoltaic cells that produce electricity which is extracted by conductors and is cooled by the water flowing through the tubes, which is also used for domestic consumption. The hot water is stored in a tank to be used, for example, to meet the needs of domestic heating, hot water and cooking.
   In those cases where, at the end of the day, at least part of the heated fluid is not used, the system permits reusing said fluid. To this end, the system further comprises a return line to the system start point so that the unused heated liquid is recirculated through the set of tubular bodies overnight, i.e., when there is no sunlight, thereby cooling the fluid which becomes suitable for reuse the next day. The system may further comprise a second tank for storing the water cooled overnight.
   With regard to the particular characteristics of the invention, an assemblable solar energy capturing container or tubular element is provided comprising a main body formed by a wall extending between a base and an opening and having a transparent portion and a light-reflector portion, the reflective portion being placed such that, when in use, it reflects into the container, characterized in that a cross section of the reflective portion is substantially parabolic, and in that the container further comprises a first coupling point coinciding with the container opening and a second coupling point coinciding with the container base, both being complementary coupling points so that the second coupling point of a container is capable of receiving the first coupling point of another container and the second coupling point being adapted such that, when coupled to a first coupling point of another container, it allows the passage of at least one tube or conduit.
   According to this aspect, the parabolic shape of the reflective portion means that the container is capable of not only reflecting UV rays but of concentrating them in one point, namely, the focus point of the parabola. Thus, container performance as a solar energy collector element is enhanced, allowing its use for power generation. Furthermore, since it may be coupled to other containers, it enables the assembly of tubular bodies through which at least one tube or conduit can pass.
   The reflective portion may comprise a reflective sheet disposed along an inner surface of the container. Or it may comprise a reflective sheet disposed along an outer surface of the container.
   Furthermore, the reflective sheet may be a single or a double parabola. Thus, container performance as a solar collector is enhanced.
   With regard to the tubes through which the cooling water flows, the system may comprise only one or two tubes, one inside another. In the latter case the cold water rises through one and the hot water goes down the other.
   The photovoltaic cell is adhered to the outside of the tube such that it is maintained at a cooler temperature and therefore closer to an optimum working temperature.
   In some embodiments, the first tube may be disposed inside the second tube. In further embodiments, the first and second tubes may be arranged concentrically.

The second tube or conduit may have a D-shaped cross section, at least one photovoltaic cell being arranged in at least one part of the flat portion of the D The system may comprise means to prevent moisture condensation on the wall of the plurality of containers. These means to prevent moisture condensation may comprise at least one air suction valve and air suction means or at least one gas injection valve and gas injection means. This prevents moisture from condensation that could occur in the tubular bodies formed by containers due to the cooling of the outside surfaces that are in contact with the atmosphere.

This invention is able to provide individuals from deprived areas with a low-cost high-efficiency system without the need of any specialized knowledge, which supplies electricity and hot water for domestic consumption.

### BRIEF DESCRIPTION OF THE DRAWINGS

To complete the description being made and for the purpose of providing a better understanding of the invention, a set of drawings is attached which, for the purpose of illustration and without limiting the scope of the invention, show the following:
Figure 1 shows an overview of the system for capturing solar energy according to one embodiment of the invention;
Figure 2 shows a container according to an embodiment of the invention;
Figure 3 shows two coupled containers according to one embodiment of the invention;
Figure 4 shows a sectional view of the container with the tubes and the photovoltaic cell, according to an embodiment of the invention;
Figure 5 shows a sectional view of the container with the tube and the photovoltaic cell, for a second embodiment.

Figure references relate to:
1. Assemblable container or tubular element
2. Main body of the container
3. Container wall
4. Container base
5. Upper part of the container
6. Opening of the container
7. Female coupling point between containers
8. Male coupling point between containers
10. Tubular bodies formed by a plurality of assembled containers
11. Cooling fluid
11. Heated cooling fluid
12. Reflective portion of the container wall
13. Tube for cooling fluid
13. Tube for heated cooling fluid
14. Photovoltaic cell
15. Means of connection between tubular bodies
16. Heated cooling water collector

### PREFERRED EMBODIMENT OF THE INVENTION

For a better understanding of the invention, the system according to a preferred embodiment is described below.

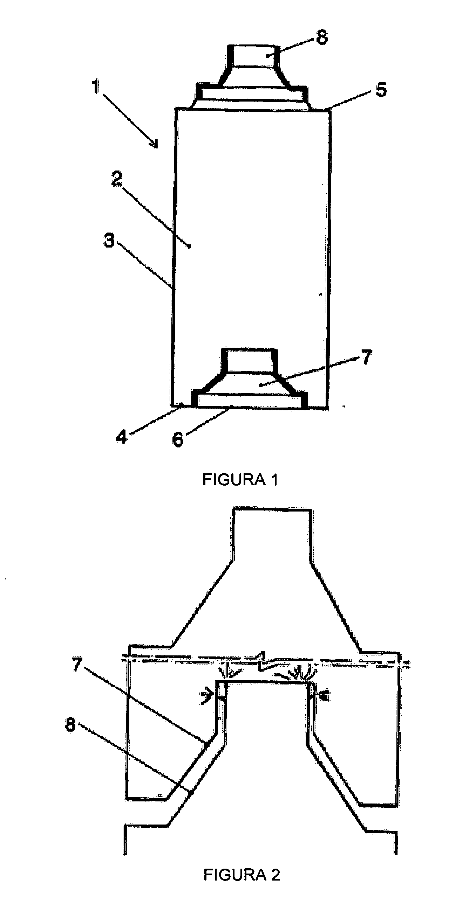

Figure 1 shows a view of a container according to an embodiment of the invention. The container (1) comprises a main body (2) formed by a wall (3) extending between a base (4) and the upper part of the container (5), a first female coupling point (7) coinciding with the opening (6) of the container and a second male coupling point (8) coinciding with the upper part (5) of the container.

Figure 2 shows two coupled containers wherein the two coupling points (7) and (8) are complementary, namely, the male coupling point (8) is assembled to the female coupling point (7) of another similar container.

When containers (1) are assembled, the coupling points (7) and (8) allow the passage of at least one conduit.

The containers may be containers of liquids, such as soft drink bottles manufactured for this purpose of reuse, so that once their liquid container function has been accomplished, they are reused having a use which is totally different from their initial use. Thus, containers that would normally be disposed of are reused for the construction of a system to capture solar energy and just purchasing the kit with the additional elements would be sufficient to assemble a system of this type at home, being substantially cheaper.

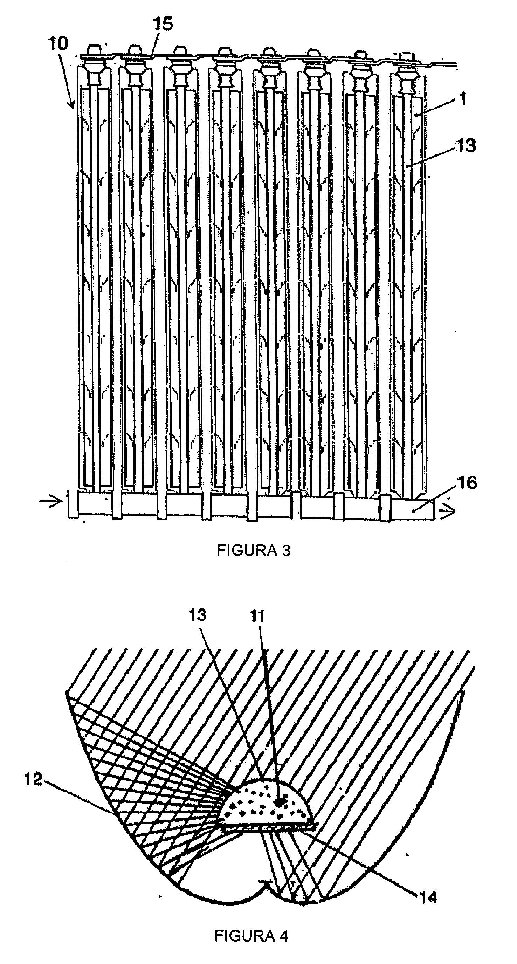

Figure 3 shows a sectional view of a container, according to a preferred embodiment. Each system container (1) comprises a wall (3). The wall (3) has a transparent portion and a light-reflector portion (12). The reflective portion (12) may be a reflective sheet disposed along an outer surface of the wall (3) of the container (1) or it may consist of an inner lining already imprinted on the container (1). In either case the function is the same, namely, to reflect solar radiation into the container (1).

According to Figure 3, the tube or conduit for the cooling fluid (13) has a semi-circular cross section (D-shaped) and is arranged in the focus point of the reflective area (12) having a double parabolic shape. On the outer surface of the cooling fluid tube (13) a photovoltaic cell (14) is disposed on at least part of the flat portion of the D, facing the reflective area (12). Thus, electrical energy is obtained and, in addition, the flow of fluid (11) through the cooling fluid conduit (13) maintains the photovoltaic cell (14) at an optimum working temperature.

Figure 4 shows a section similar to that of Figure 3 for a second embodiment. The reflective area (12) is also a double parabola. Furthermore, the cooling fluid tube (13) has a circular cross section and the photovoltaic cell (14) is arranged on the outside of the conduit (13). Inside the cooling fluid tube (13) another tube smaller in diameter is arranged, being the tube for heated cooling fluid (13'), that is, the return line of the cooling fluid (11') once heated if a collector is not available at the top of the system.

With regard to the configuration of the cooling circuit, there are two preferred embodiments:
- If the system is connected in parallel, namely, the cooling water flowing through each tubular body (10) is independent, then inside the cooling fluid tube (13) there is another tube smaller in diameter, this being the tube for heated cooling fluid (13'), that is, the return line of the cooling fluid (11') once heated and the heated water is collected in a collector (16) located in the lower part of the system, (shown in Figure 4)
- If the system is connected in series, namely, the cooling water enters through the top end of the first tubular body (10) and goes out the bottom end of the last tubular body (10), then the cooling tubes (13) are connected to each other instead of being connected to a general collector (shown in Figure 3).

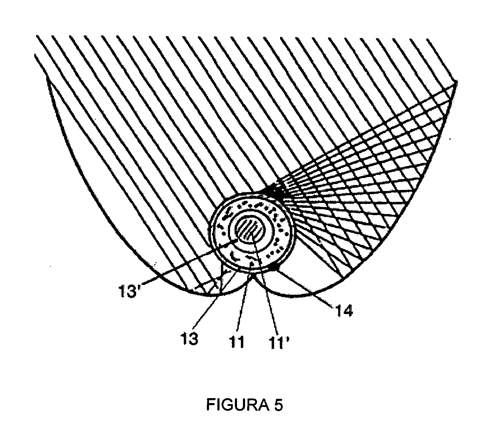

Figure 5 shows a system for capturing solar energy according to an embodiment of the invention comprising a plurality of containers (1) coupled together so as to form tubular bodies (10). Specifically, Figure 1, shows eight tubular bodies (10) formed with eight containers (1) each. The number of tubular bodies (10) may vary from one system to another, as well as the number of containers (1) forming each of the tubular bodies (10).

Each tubular body (10) has at least one fluid conduit (13) going through it.

Each tubular body (10) is disposed parallel to another tubular body (10) and the system comprises connecting means (15) between one tubular body (10) and another adjacent one. Said connecting means (15) are coupled at the end of each tubular body (10).

The connecting means (15) are pipe connection fittings in the case of series configuration, enabling the flow of cooling water (11). Certain mechanical connections are also required, such as flanges, sleeves, clamps or joints, as well as electrical connections of the photovoltaic cells to the electrical conductors, all common in the prior art.

Although the main application of the invention is home consumption, its use in other fields requiring a similar application is not ruled out.

## Claims

1. Modular system for capturing photovoltaic solar energy for domestic use, being economical and easy to assemble, comprising the following elements:
- A plurality of assemblable tubular elements (containers) (1),
- Reflective surface (12) for said containers,
- At least one tube (13) for circulation of the cooling fluid (11),
- Photovoltaic cells (14) attached to the cooling pipe,
- Electric conductors to channel the energy produced,
- At least one cooling water collector (16).

2. Modular system for capturing photovoltaic solar energy according to claim 1 **characterized in that** the container (1) comprises a main body (2) formed by a wall (3) extending from a base (4) and the upper part of the container (5), a first female coupling point (7) coinciding with an opening (6) in the container at the base (4) and a second male coupling point (8) coinciding with the upper part (5) of the container.

3. Modular system for capturing photovoltaic solar energy according to claim 2 **characterized in that** the containers are assembled together, both coupling points (male and female, (7) and (8)) being complementary, i.e. the male coupling point (8) is assembled to the female coupling point (7) of another similar container.

4. Modular system for capturing photovoltaic solar energy according to claim 3 **characterized in that** upon assembly of the containers (1), the coupling points (7) and (8) allow the passage of at least one conduit.

5. Modular system for capturing photovoltaic solar energy according to claim 2 **characterized in that** the wall (3) has a transparent portion and a light-reflector portion (12).

6. Modular system for capturing photovoltaic solar energy according to claim 5 **characterized in that** the reflective portion (12) is a reflective sheet disposed along an outer surface of the wall (3) of the container (1).

7. Modular system for capturing photovoltaic solar energy according to claim 5, **characterized in that** the reflective portion (12) consists of an inner lining that is already imprinted on the container (1).

8. Modular system for capturing photovoltaic solar energy according to claim 6 **characterized in that** the reflective sheet is a single parabola.

9. Modular system for capturing photovoltaic solar energy according to claim 6 **characterized in that** the reflective sheet is a double parabola.

10. Modular system for capturing photovoltaic solar energy according to claim 2 **characterized in that** the cooling fluid tube or conduit (13) has a semi-circular cross section (D-shaped) and is arranged in the focus point of the reflective area (12), and on the outer surface of the cooling fluid tube (13) a photovoltaic cell (14) is arranged on at least part of the flat portion of the D, facing the reflective area (12).

11. Modular system for capturing photovoltaic solar energy according to claim 2 **characterized in that** the cooling fluid tube or conduit (13) has a circular cross section and is arranged in the focus point of the reflective area (12), and on the outer surface cooling fluid tube (13) a photovoltaic cell (14) is arranged facing the reflective area (12).

12. Modular system for capturing photovoltaic solar energy according to claim 2 **characterized in that** inside the cooling fluid tube (13) there is another tube smaller in diameter, this being the tube for heated cooling fluid (13'), i.e., the return line of the cooling fluid (11') once heated and the heated water is collected in a collector (16) located at the bottom of the system.

13. Modular system for capturing photovoltaic solar energy according to claim 2 **characterized in that** it comprises a plurality of containers (1) coupled together so as to form tubular bodies (10), each tubular body (10) having at least one fluid conduit (13) going through it, and each tubular body (10) being arranged parallel to another tubular body (10) and with connecting means (15) between one tubular body (10) and an adjacent one, said connecting means (15) being coupled at the end of each tubular body (10).

14. Modular system for capturing photovoltaic solar energy according to claim 1 **characterized in that** it comprises means to prevent moisture condensation on the wall (2) of the plurality of containers.

15. The system according to claim 14 **characterized in that** the means to prevent moisture condensation comprise at least one air suction valve and air suction means.

16. System according to claim 14, **characterized in that** the means to prevent moisture condensation comprise at least one gas injection valve and gas injection means.
